# EUROPEAN PATENT APPLICATION

(11) **EP 4 092 868 A1**
(43) Date of publication of application: **23.11.2022**
(21) Application number: 22174550.8
(22) Date of filing: 20.05.2022
(51) Int. Cl.: H02J 7/00

(54) **COMMUNICATION CIRCUIT, ELECTRONIC SYSTEM, BATTERY PACK, AND ELECTRICAL DEVICE**

(30) Priority: 20.05.2021 CN 202110553994
(71) Applicant: DONGGUAN POWERAMP TECHNOLOGY LIMITED, Dongguan City, Guangdong Province 523000 (CN)
(72) Inventor: QIN, Youqiang, Dongguan City, Guangdong Province, 523000 (CN); LI, Zili, Dongguan City, Guangdong Province, 523000 (CN)
(74) Representative: Klunker IP Patentanwälte PartG mbB

(57) **Abstract**

Embodiments of this application relate to the technical field of electronic circuits, and in particular, to a communication circuit, an electronic system, a battery pack, and an electrical device. The communication circuit includes: a transmitting module, configured to transmit a signal through a communication connection wire when the communication circuit is in a transmitting state, where the communication connection wire is connected to a common positive pole shared by two communication circuits; and a receiving module, configured to receive the signal through the communication connection wire when the communication circuit is in a receiving state. When the communication circuit is in the transmitting state, the transmitting module is activated and the receiving module is deactivated. When the communication circuit is in the receiving state, the transmitting module is deactivated and the receiving module is activated. Communication connection is implemented between different subsystems by connecting to the common positive pole. Even if a ground wire between systems is disconnected, the communication function is prevented from being affected, thereby improving reliability effectively.

## Description

### TECHNICAL FIELD

This application relates to the technical field of electronic circuits, and in particular, to a communication circuit, an electronic system, a battery pack, and an electrical device.

### BACKGROUND

With the ongoing development of electronic information technology, an electronic device needs to be compatible with or integrate more functions. A complete electronic system such as a battery management system (BMS) needs to include more subsystems or sub-modules.

To transfer data or instructions between systems, a communication circuit with a sufficient load capacity and sufficient reliability needs to be provided, and communication connections between the subsystems or the sub-modules need to be established. However, in conventional design of communication circuits, a common-negative-pole connection mode is usually adopted. In a case that the circuit is based on a low voltage such as 5 V, communication connection is implemented between two subsystems or sub-modules by a data wire connected to a common negative pole or a common ground.

In such a communication circuit, because communication is performed between systems based on a common negative pole, the communication circuit and communication function are prone to fail once a ground wire between the two subsystems or modules is disconnected. Therefore, it is urgent to provide a more reliable communication circuit.

### SUMMARY

Embodiments of this application aim to provide a communication circuit, an electronic system, a battery pack, and an electrical device to overcome a defect existent in a conventional communication circuit.

To achieve the foregoing technical objective, an embodiment of this application provides the following technical solution: a communication circuit. The communication circuit includes a transmitting module configured to transmit a signal through a communication connection wire when the communication circuit is in a transmitting state, and a receiving module configured to receive the signal through the communication connection wire when the communication circuit is in a receiving state. The communication circuit is connected to another communication circuit by the communication connection wire so the communication circuit and the another communication circuit connected by the communication connection wire share a common positive pole, and the communication connection wire is connected to the common positive pole.

When the communication circuit is in the transmitting state, the transmitting module is activated and the receiving module is deactivated. When the communication circuit is in the receiving state, the transmitting module is deactivated and the receiving module is activated.

Optionally, the transmitting module includes: a first controllable switch unit disposed between the communication connection wire and the common positive pole.

The first controllable switch unit is configured to cut off or establish a connection between the communication connection wire and the common positive pole, so as to form different level signals on the communications connection wire.

Optionally, when the communication circuit is in the receiving state, the first controllable switch unit keeps cutting off the connection between the communication connection wire and the common positive pole, so as to deactivate the transmitting module.

When the communication circuit is in the transmitting state, the first controllable switch unit is configured to cut off or establish the connection between the communication connection wire and the common positive pole based on the transmitted signal, so as to form a level signal on the communications connection wire, where the level signal is consistent with the transmitted signal.

Optionally, the first controllable switch unit specifically includes: a first switch with a first control terminal and a second switch with a second control terminal.

Two ends of the first switch are connected to the common positive pole and the communication connection wire respectively. When the first switch is turned on, the connection between the common positive pole and the communication connection wire is established; and, when the first switch is cut off, the connection between the common positive pole and the communication connection wire is cut off. The first control terminal is connected to the second switch, and is configured to control the first switch to turn on when the second switch is turned on, and control the first switch to cut off when the second switch is cut off. The second control terminal is configured to control the second switch to turn on or cut off based on the transmitted signal.

Optionally, the receiving module includes: a second controllable switch unit, a follower unit, and a signal receiving port. The follower unit is connected to the signal receiving port. The second controllable switch unit is connected to the communication connection wire, and is configured to control the follower unit based on a level signal of the communication connection wire, and form a consistent level signal at the signal receiving port.

Optionally, the follower unit specifically includes: a constant voltage source, a third switch with a third control terminal, and a pull-down resistor. One end of the pull-down resistor is grounded, and the other end is connected to the signal receiving port. The third switch is connected between the constant voltage source and the signal receiving port. The second controllable switch unit is connected to the third control terminal, and is configured to control the third switch to turn on or cut off, and form a high-level signal or a low-level signal at the signal receiving port.

Optionally, when the communication circuit is in the transmitting state, the second controllable switch unit controls the third switch to keep cutting off, so as to deactivate the receiving module. When the communication circuit is in the receiving state, the second controllable switch unit is configured to control the third switch to cut off or turn on based on the signal from the communication connection wire, so as to form a level signal at the signal receiving port, where the level signal is consistent with the level signal of the communication connection wire.

Optionally, the second controllable switch unit includes: an enable-signal receiving port configured to receive an enable signal, where the enable signal includes a first enable signal used for activating the receiving module and a second enable signal used for deactivating the receiving module.

The second controllable switch unit is connected between the third control terminal and a ground, and is configured to cut off or establish a connection between the third control terminal and the ground, so as to turn on or cut off the third switch. When the second enable signal is received, the second controllable switch unit keeps cutting off the connection between the third control terminal and the ground, so as to keep cutting off the third switch. When the first enable signal is received, the second controllable switch unit cuts off or establishes the connection between the third control terminal and the ground based on the level signal of the communication connection wire, so as to cut off or turn on the third switch.

Optionally, the second controllable switch unit includes: a fourth switch with a fourth control terminal and a fifth switch with a fifth control terminal, and the fifth switch is connected to the fourth switch in series.

The fourth control terminal is connected to the communication connection wire, and is configured to receive the signal from the communication connection wire, and the fifth control terminal is connected to the enable-signal receiving port. When the first enable signal is received, the fourth control terminal is configured to control the fourth switch and the fifth switch to turn on or cut off based on the signal from the communication connection wire. When the second enable signal is received, the fifth control terminal is configured to control the fourth switch and the fifth switch to keep cutting off.

Optionally, the transmitting module and/or the receiving module further includes: several one-way conduction elements. The one-way conduction elements are disposed inside the receiving module, at a first junction and/or at a second junction. Specifically, the first junction is a junction between the transmitting module and the communication connection wire, and the second junction is a junction between the receiving module and the communication connection wire.

Optionally, the transmitting module and/or the receiving module further includes: a current limiting protector and an electrostatic discharge protector. The current limiting protector and/or the electrostatic discharge protector is connected to the second control terminal, the signal receiving port, the enable-signal receiving port, and/or the fourth control terminal.

Optionally, the first to fifth switches each include several control elements. The control elements may include a transistor, a MOS transistor, and/or an optocoupler.

Optionally, the transmitting module includes: a first transistor, a fourth transistor, a third resistor, a fifth resistor, a ninth resistor, and a twelfth resistor.

The first transistor and the third resistor may form the first switch. Abase of the first transistor is connected to the first control terminal. The third resistor is connected between the base and an emitter of the first transistor to serve as a bias resistor. An emitter and a collector of the first transistor are coupled to the common positive pole and the communication connection wire respectively.

The fourth transistor, the twelfth resistor, and the ninth resistor may form the second switch. A base of the fourth transistor is connected to the second control terminal. The twelfth resistor is connected between a base and an emitter of the fourth transistor to serve as a bias resistor. The ninth resistor is connected between the base of the first transistor and a signal transmitting port to serve as a current limiting resistor. A collector of the fourth transistor is connected to the base of the first transistor by the fifth resistor.

Optionally, the transmitting module may further include: a first resistor, a first capacitor, and a first diode. The first resistor is a current limiting resistor connected between the collector of the first transistor and the communication connection wire. The first capacitor is connected across the first resistor. An anode of a one-way conducting first diode is connected to the first resistor, and a cathode is connected to the communication connection wire.

Optionally, the receiving module includes: a second transistor, a third transistor, a fifth transistor, a sixth resistor, a seventh resistor, an eighth resistor, a tenth resistor, an eleventh resistor, and a thirteenth resistor.

The eleventh resistor is a pull-down resistor of the follower unit. The third transistor and the seventh resistor may form a third switch of the follower unit. Abase of the third transistor is connected to the third control terminal. The seventh resistor is connected between the base and an emitter of the third transistor to serve as a bias resistor. A collector of the third transistor is connected to a constant voltage source. The emitter of the third transistor is connected to one end of the eleventh resistor, and extends outward to form a signal receiving port. The other end of the eleventh resistor is grounded.

The second transistor and the sixth resistor form the fourth switch. A base of the second transistor is connected to the fourth control terminal. The sixth resistor is connected between the base and an emitter of the second transistor to serve as a bias resistor.

The fifth transistor, the tenth resistor, and the thirteenth resistor form the fifth switch. Abase of the fifth transistor is connected to the fifth control terminal. The thirteenth resistor is connected between the base and an emitter of the fifth transistor to serve as a bias resistor. The tenth resistor is connected between the base of the fifth transistor and an enable-signal receiving port to serve as a current limiting resistor.

In addition, the base of the third transistor is connected to the collector of the second transistor by the eighth resistor. The emitter of the second transistor is connected to the collector of the fifth transistor, and the emitter of the fifth transistor is grounded.

Optionally, resistance values of the first to thirteenth resistors are determined based on at least one of: a voltage of the common positive pole, status of the transistor in different voltage ranges, and leakage current characteristics.

To achieve the foregoing technical objective, an embodiment of this application further provides the following technical solution: an electronic system. The electronic system includes two subsystems, each subsystem includes a processor and the communication circuit described above.

The processor is connected to the communication circuit, and is configured to: control the communication circuit to switch between the receiving state and the transmitting state; and one subsystem transmits, through the transmitting module when the communication circuit is in the transmitting state, a target signal to the other subsystem system connected to a communication connection wire; and, one subsystem receives, through the receiving module when the communication circuit is in the receiving state, the target signal transmitted by the other subsystem system.

Optionally, the processor works in at least one low-power-consumption mode, and the target signal includes a wake-up signal used for causing the processor to exit the low-power-consumption mode. When the processor enters the low-power-consumption mode, the processor controls the communication circuit to be in the receiving state. When the wake-up signal from the other electronic system is received by the receiving module, the processor exits the low-power-consumption mode.

Optionally, the wake-up signal is an interruption signal formed by transition between a high level and a low level.

Optionally, the electronic system includes a first subsystem and a second subsystem. The first subsystem includes a first processor and the first communication circuit. The second subsystem includes a second processor and the second communication circuit.

When the first processor enters the low-power-consumption mode, the first communication circuit is configured to be in a receiving state. Through the second communication circuit configured to be in a transmitting state, the second processor transmits an interruption signal formed by transition between the high level and the low level, so that the first processor exits the low-power-consumption mode when receiving the interruption signal through the first communication circuit.

To achieve the foregoing technical objective, an embodiment of this application further provides the following technical solution: a battery pack. The battery pack includes the electronic system and a cell module.

To achieve the foregoing technical objective, an embodiment of this application further provides the following technical solution: an electrical device. The electrical device includes: the battery pack and a load powered by the battery pack.

The communication circuit according to the embodiments of this application implements communication connection between different subsystems by connecting to the common positive pole. Signals can be transmitted by the communication connection wire connected to the common positive pole. Even if a ground wire between systems is disconnected, the communication function is prevented from being affected, thereby improving reliability effectively.

### BRIEF DESCRIPTION OF DRAWINGS

One or more embodiments are described exemplarily with reference to accompanying drawings corresponding to the embodiments. The exemplary description does not constitute any limitation on the embodiments. Components marked with the same reference numeral in the drawings represent similar components. Unless otherwise specified, the drawings do not constitute any scale limitation.
FIG. 1 is a schematic diagram of an electronic system according to an embodiment of this application;
FIG. 2 is a schematic diagram of a communication circuit according to an embodiment of this application;
FIG. 3 is a schematic circuit diagram of a communication circuit according to an embodiment of this application;
FIG. 4 is a schematic circuit diagram of a communication circuit according to another embodiment of this application; and
FIG. 5 is a sequence diagram of signal transfer of a communication circuit according to an embodiment of this application.

### DETAILED DESCRIPTION OF EMBODIMENTS

For ease of understanding this application, the following describes this application in more detail with reference to drawings and specific embodiments. It needs to be noted that an element referred to herein as "fixed to" another element may directly exist on the other element, or may be fixed to the other element through one or more intermediate elements. An element referred to herein as "connected to" another element may be connected to the other element directly or through one or more intermediate elements. A direction or a positional relationship indicated by the terms such as "up", "down", "in", "out", and "bottom" used herein is a direction or positional relationship based on the illustration in the drawings, and is merely intended for ease or brevity of describing this application, but does not indicate or imply that the indicated device or component is necessarily located in the specified direction or constructed or operated in the specified direction. Therefore, such terms are not to be understood as a limitation on this application. In addition, the terms "first", "second", and "third" are merely intended for descriptive purposes, but are not intended to indicate or imply order of precedence.

Unless otherwise defined, all technical and scientific terms used herein have the same meanings as what is generally understood by a person skilled in the technical field of this application. The terms used in the specification of this application are merely intended to describe specific embodiments but not to limit this application. The term "and/or" used herein is intended to include any and all combinations of one or more related items preceding and following the term.

In addition, the technical features described below and mentioned in different embodiments of this application may be combined with each other so long as they do not conflict with each other.

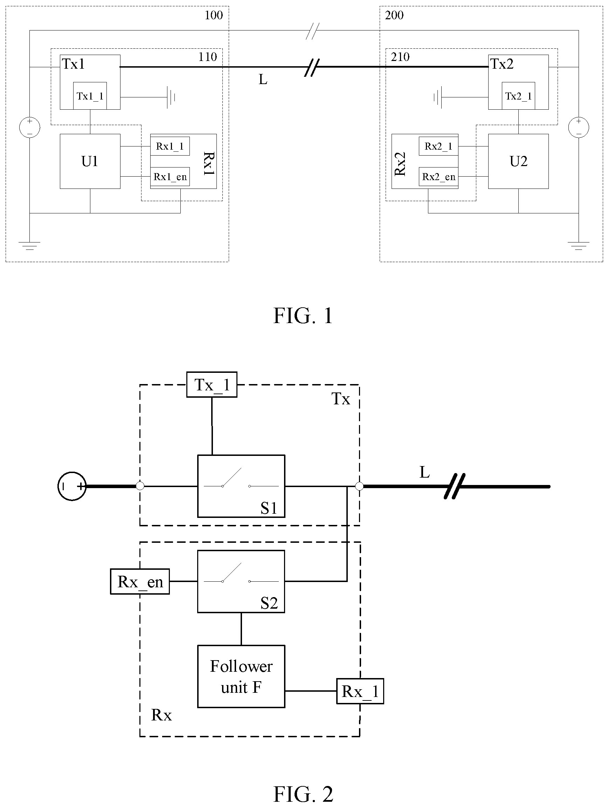

FIG. 1 is a schematic diagram of an electronic system according to an embodiment of this application. This application does not limit the specific implementation of the electronic system. The electronic system may be any type of device or apparatus that includes an electrical signal processing part and an electrical signal transfer part. Examples include a battery pack that includes a plurality of battery cells, a charger configured to charging a battery pack, and an electrical device powered by the battery pack.

As shown in FIG. 1, the electronic system includes a plurality of different subsystems. The subsystems are configured to perform different functions separately (for example, a sampling system configured to acquire current/voltage of a battery cell in the battery pack, and a battery management system configured to manage charging and discharging states of each battery cell in the battery pack). Two subsystems is connected in communication to each other through a communication circuit.

In this embodiment, for brevity of description, two subsystems are used as examples, referred to as a "first subsystem" and a "second subsystem" respectively. A first subsystem 100 is connected to a second subsystem 200 by connecting to a "common positive pole". That is, both subsystems are connected to the common positive pole+. In this embodiment, a complete electronic system formed by the first subsystem 100 and the second subsystem 200 that are connected to the common positive pole may be referred to as a "common-positive-pole system".

To describe this application thoroughly, one or more functional modules in different subsystems are omitted from the drawings or considered to have been integrated into a functional module referred to as a "processor". The processor may be any type of electronic computing platform based on a chip capable of logical operation (such as a microcontroller unit MCU) and including one or more peripheral function modules.

In some embodiments, the processor of one or more subsystems may work in a low-power-consumption mode different from a normal working mode. The "low-power-consumption mode" means an operation mode in which some functions in a subsystem are suspended and only a part of circuits keeps running so that the power consumption is lower than that in a normal working state, and is referred to as a "low-power-consumption mode" because the power consumption in such a mode is lower than that in the normal working mode of the subsystem. Definitely, after receiving a specific or preset wake-up signal, the processor in the low-power-consumption mode can be activated or woken up to switch from the low-power-consumption mode to the normal working mode.

Still referring to FIG. 1, the first subsystem 100 may include a first communication circuit 110 and a first processor U1, and the second subsystem 200 includes a second communication circuit 210 and a second processor U2.

The first processor U1, the second processor U2, the first communication circuit 110, and the second communication circuit 210, as independent function modules, can form or provide several different connection ports that are configured to transmit or receive different data or level signals separately to implement corresponding functions.

For example, at least three connection ports may exist between the first processor U1 and the first communication circuit 110 that belong to a same subsystem, and may be configured to transmit signals, receive signals, and control operation status of the communication circuit, respectively. A similar structural design may be applied between the second processor U2 and the second communication circuit 210.

The first communication circuit 110 and the second communication circuit 210 belonging to different subsystems are connected to each other by a single communication connection wire L. The communication connection wire L is also connected to the common positive pole. The voltage of the communication connection wire L may be higher than 10 V or 5 V, and is a high-voltage communication wire (compared to a conventional low-voltage communication wire such as a 5 V data wire).

In this way, by using the first communication circuit 110 and the second communication circuit 210, the communication connection can be implemented between the first subsystem 100 and the second subsystem 200. The "communication connection" may mean that, for a level signal transmitted by a processor (U1 or U2) in one of the subsystems, the same level signal can be formed in a processor (U1 or U2) in the other subsystem through the communication circuit (110, 210).

For example, for a level signal (such as a high-level signal or a low-level signal) delivered by the first processor U1, the second processor U2 can receive a level signal identical to the delivered level signal through mutual coordination between the first communication circuit 110 and the second communication circuit 210.

The electronic system according to this embodiment of this application implements the communication connection between the two subsystems based on the communication connection wire L connected to the common positive pole. Even if the ground wire between the subsystems is disconnected or the sub-systems do not share a common ground or in other circumstances, the normal communication function can also be ensured, thereby being more reliable than the conventionally designed communication circuit.

In some embodiments, in order to meet the need of transmitting signals between the two subsystems, as shown in FIG. 1, the first communication circuit 110 may include: a first transmitting module Tx1 and a first receiving module Rx1. The second communication circuit 210 also includes: a second transmitting module Tx2 and a second receiving module Rx2.

Both the first transmitting module Tx1 and the second transmitting module Tx2 are circuits configured to transmit signals to another communication circuit through the communication connection wire L. Both the first receiving module Rx1 and the second receiving module Rx2 are circuits configured to receive signals from another communication circuit through the communication connection wire L.

In some embodiments, in a case of using a single communication connection wire L, in order to implement two-way communication between the first subsystem 100 and the second subsystem 200, the first communication circuit 110 and the second communication circuit 210 need to be so restricted that signals are transferred in only one direction at a time.

In other words, when the first communication circuit 110 communicates with the second communication circuit 210, either the transmitting module (Tx1 or Tx2) or the receiving module (Rx1 or Rx2), but not both the transmitting module and the receiving module, of the first communication circuit 110 or the second communication circuit 210 can be activated at a time. Moreover, the transmitting modules (Tx1 and Tx2) of the first communication circuit 110 and the second communication circuit 210 cannot be activated at a time, and the receiving modules (Rx1 and Rx2) of both circuits cannot be activated at a time.

For example, when the first transmitting module Tx1 of the first communication circuit 110 is activated, the first receiving module Rx1 is deactivated. In addition, when the second receiving module Rx2 of the second communication circuit 210 is activated, the second transmitting module Tx2 is kept in the deactivated state.

For brief description of the specification hereof, an operating state in which the transmitting module is activated, the receiving module is deactivated, and the communication circuit is configured to only transmit signals, is referred to as a "transmitting state", and an operating state in which the receiving module is activated, the transmitting module is deactivated, and the communication circuit is configured to only receive signals, is referred to as a "receiving state".

Specifically, the operating status of the first communication circuit 110 and the second communication circuit 210 may be controlled by the processors (U1 and U2) of the corresponding subsystems. The following describes in detail the connection and control manners of the processor and the communication circuit, using the first communication circuit 110 as an example. The connection and control manners for the second communication circuit 210 are similar to those for the first communication circuit 110, and are omitted herein for brevity.

For example, as shown in FIG. 1, the transmitting module Tx1 of the first communication circuit 110 includes a signal transmitting port Tx1_1 connected to the first processor U1. The receiving module Rx1 of the first communication circuit includes a signal receiving port Rx1_1 and an enable-signal receiving port Rx1_en that are connected to the first processor U1 and that are configured to deliver a received signal to the first processor U1 and receive an enable signal from the first processor U1 respectively.

The first processor U1 is connected to the signal transmitting port Tx1_1 in a way similar to the use of a signal transmitting wire or the like, and controls the transmitting module Tx1 by delivering a high-level signal or a low-level signal or the like. The first processor U1 is further connected to the enable-signal receiving port Rx1_en of the receiving module Rx1, and controls the receiving module Rx1 by delivering an enable signal.

It needs to be noted that, for ease of description, this application divides a communication circuit into corresponding circuit modules based on the functions to be performed, and the division by function is not intended to limit this application.

FIG. 2 is a schematic structural diagram of a communication circuit according to an embodiment of this application. The communication circuit may be a first communication circuit, a second communication circuit, or any other circuit module that is configured to establish a communication connection in practical applications.

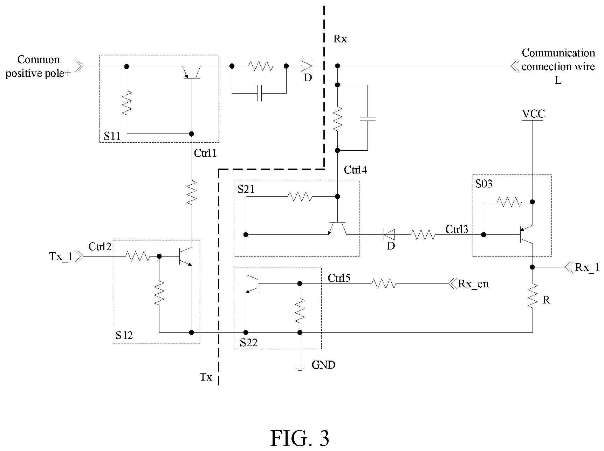

FIG. 3 is a schematic circuit diagram of a communication circuit according to an embodiment of this application. The communication circuit shown in FIG. 3 is one of implementations of the communication circuit shown in FIG. 2, and is not intended to limit this application.

The specific structure and composition of the two relatively independent function modules (the transmitting module Tx and the receiving module Rx) will be described in detail below with reference to the communication circuits shown in FIG. 2 and FIG. 3.

As shown in FIG. 2, the transmitting module Tx may include: a first controllable switch unit S1 disposed between the communication connection wire L and the common positive pole+.

The first controllable switch unit S1 is a circuit element configured to cut off or establish a connection between the communication connection wire L and the common positive pole+. The first controllable switch unit may be specifically implemented by any type or form of circuit module that includes one or more electrical elements.

Specifically, the "switch unit" means a circuit structure that switches between at least two states, a conducted state (on-state) and a cut-off state (off-state), so that elements connected at two ends of the switch unit can switch between a connected state and a disconnected state. "Controllable" means automatic switching between the on-state and the cut-off state based on an appropriate control signal delivered by other function modules such as a processor. In other words, the switch unit may be controlled by the control signal.

In other embodiments, the first controllable switch unit S1 not only controls the level signal formed on the communication connection wire L, but may be also configured to control operating status of the transmitting module Tx1 to ensure orderly transfer of level signals on the communication connection wire L.

Specifically, when the communication circuit is in the receiving state and the transmitting module Tx needs to be deactivated, the processor may deliver a continuous deactivation control signal to the signal transmitting port Tx_1, so that the first controllable switch unit S1 is kept in the cut-off state to cut off the connection between the communication connection wire L and the common positive pole+.

When the communication circuit is in the transmitting state, the processor may directly deliver a to-be-transmitted target signal to the signal transmitting port Tx_1 directly. In this case, the first controllable switch unit S1 can switch between the on-state and the cut-off state correspondingly based on the changed target signal from the processor, so as to form a level signal on the communication connection wire L, where the level signal is consistent with the to-be-transmitted target signal.

Specifically, as shown in FIG. 3, the first controllable switch unit S1 may include: a first switch S11 with a first control terminal Ctrl1 and a second switch S12 with a second control terminal Ctrl2.

"Switch" means an electrical element arranged in a circuit and capable of closing or opening the circuit. Each switch in this embodiment includes at least one control terminal. The switch can switch between the on-state and the cut-off state in response to a control signal injected at the control terminal, so as to achieve the "controllable" effect.

In this embodiment, the terms such as "first" and "second" are merely intended to distinguish between a plurality of elements of the same type (such as switches), but not intended to limit the elements modified by the terms. The terms may be adjusted or replaced according to the need of description.

Specifically, the "switch" may be a component formed by several control elements according to given connection logic and capable of turning on or off in response to different control signals. The control elements include electrical elements such as a transistor, a MOS transistor, an optocoupler, and the like, which switch between at least two different states, an "on" state and a "cut-off" state, and which can serve a switching function.

Still referring to FIG. 3, two ends of the first switch S11 are connected to the common positive pole+ and the communication connection wire L respectively, so that the first switch S11 can establish a connection between the communication connection wire L and the common positive pole+ when conducted, and cut off the connection between the common positive pole+ and the communication connection wire L when cut off.

The second control terminal Ctrl2 of the second switch S12 may be connected to the signal transmitting port Tx_1, and configured to receive the target signal delivered by the processor. The first control terminal Ctrl1 of the first switch S11 is connected to the second switch S12, so that the first switch S11 can change status with the status change of the second switch S12. For example, the first control terminal Ctrl1 controls the first switch S11 to turn on when the second switch S12 is turned on, and controls the first switch S11 to turn off when the second switch S12 is turned off.

During actual operation of the transmitting module Tx, the processor needs to deliver the target signal to the second control terminal Ctrl2 to control the second switch S12 to turn on or cut off. The first switch S11 changes correspondingly with the status change of the second switch, so as to establish or cut off the connection between the communication connection wire L and the common positive pole+ to generate a level signal consistent with the target signal.

Still referring to FIG. 2, the receiving module Rx may include: a second controllable switch unit S2, a follower unit F, and a signal receiving port Rx_1.

The signal receiving port Rx_1 is a node on which the receiving module Rx of the communication circuit forms a level signal, and can feed back the level signal on the communication connection wire L to the processor of the subsystem.

The second controllable switch unit S2 is a circuit element similar to the first controllable switch unit S1. The second controllable switch unit is connected between the communication connection wire L and the follower unit F, and primarily serves to control the action of the follower unit F based on the level change of the communication connection wire L.

The follower unit F means a circuit element that can pull up the level of the signal receiving port Rx_1 to form a high-level signal or pull down the level of the signal receiving port to form a low-level signal. Under the control of the second controllable switch unit S1, the follower unit can cause the signal receiving port Rx_1 to generate a high-level signal or a low-level signal consistent with the level signal on the communication connection wire L.

During actual operation of the receiving module Rx, the second controllable switch unit S2 controls the follower unit F to pull up or pull down the level of the signal receiving port Rx_1 based on the change of the level signal on the communication connection wire L, so that the follower unit can change with the change of the level signal on the communication connection wire L. In this way, the target signal transmitted by the processor of another subsystem is delivered to the processor of this subsystem.

Specifically, still referring to FIG. 3, the follower unit F may include: a constant voltage source VCC, a third switch S03 with a third control terminal Ctrl3, and a resistor R.

The second controllable switch unit S2 is connected to the third control terminal Ctrl3, and is configured to control the third switch S03 to turn on or cut off. One end of the resistor R is grounded, and the other end is connected to the signal receiving port Rx_1. The third switch S03 is connected between the constant voltage source VCC and the signal receiving port Rx_1.

In this way, when the third switch S03 is turned on, the level of the signal receiving port Rx_1 can be pulled up by the constant voltage source VCC to form a high-level signal. When the third switch S03 is cut off, the level of the signal receiving port Rx_1 is pulled down by the resistor R to form a low-level signal, thereby implementing the functions of the follower unit F.

In other embodiments, the second controllable switch unit S2 not only causes the level of the signal receiving port to change with the change of the level of the communication connection wire L, but is also configured to control the operating status of the receiving module Rx based on the control signal delivered by the processor.

In contrast to the control manner exercised by controlling the transmitting module Tx disclosed in the foregoing embodiment, in this embodiment, the receiving module Rx includes an enable-signal receiving port Rx_en dedicated to status control and configured to receive an enable signal from the processor. The enable signal used by the processor to control the operating status of the receiving module Rx may include a first enable signal used for activating the receiving module and a second enable signal used for deactivating the receiving module.

Using the structure of the follower unit F in FIG. 3 as an example, the second controllable switch unit S2 formed by the fourth switch S21 and the fifth switch S22 may be connected between the third control terminal Ctrl3 and a ground GND, and can cut off or establish a connection between the third control terminal Ctrl3 and the ground, so as to turn on or cut off the third switch S03.

When the communication circuit is in the transmitting state and the receiving module needs to be deactivated, the processor may deliver the second enable signal to the enable-signal receiving port Rx_en, so that the second controllable switch unit S2 controls the third switch S03 to keep the cut-off state, and that the signal receiving port Rx_1 is kept at a low level.

When the communication circuit is in the receiving state and the receiving module is activated, the processor may deliver the first enable signal to the enable-signal receiving port Rx_en, so that the second controllable switch unit S2 is in a controllable state. In this case, the second controllable switch unit S2 may control the third switch S03 to cut off or turn on based on the change of the level signal on the communication connection wire L, so that a consistent level signal is formed on the signal receiving port Rx_1 and delivered to the processor.

In some embodiments, still referring to FIG. 3, the second controllable switch unit S2 includes: a fourth switch S21 and a fifth switch S22 that are connected in series.

The fourth switch S21 includes a fourth control terminal Ctrl4 connected to the communication connection wire L, and can turn on or cut off in response to a change in the level signal of the communication connection wire L. The fifth switch S22 includes a fifth control terminal Ctrl5 connected to the enable-signal receiving port Rx_en and configured to receive the enable signal from the processor.

"Connected in series" is a connection pattern in which two switches are connected in series or the like in a circuit, and in which the second controllable switch unit S2 is not turned on unless both switches are turned on simultaneously. In other words, the second controllable switch unit S2 is not in the on-state unless both the fourth control terminal Ctrl4 and the fifth control terminal Ctrl5 receive a control signal that causes the switch to turn on. When any one of the fourth control terminal Ctrl4 or the fifth control terminal Ctrl5 receives a control signal that causes the switch to cut off, the second controllable switch unit S2 is in the cut-off state.

During actual operation of the receiving module, when the fifth control terminal Ctrl5 receives the first enable signal (a control signal that causes the fifth switch to turn on) delivered by the processor, whether to turn on or cut off the second controllable switch unit S2 depends on the level signal received by the fourth control terminal Ctrl4, and the receiving module is activated.

The fourth control terminal Ctrl4 can control the fourth switch S21 to turn on or cut off depending on the change in the level signal of the communication connection wire L. In a case that the fourth switch S21 is turned on, the fifth switch S22 is also in an on-state. In a case that the fourth switch S21 is cut off, the fifth switch S22 is also in a cut-off state.

When the fifth control terminal Ctrl5 receives the second enable signal (a control signal that causes the fifth switch to cut off) delivered by the processor, the fifth switch S22 will be kept in the cut-off state. Whatever level signal is received by the fourth control terminal Ctrl4, the fourth switch S21 is in the cut-off state, and the receiving module is deactivated.

In some embodiments, one or more one-way conducting devices D (such as diodes) configured to limit a transfer direction of a level signal may be further added in the transmitting module Tx and the receiving module Rx, so as to ensure a correct direction of signal transfer in the communication circuit.

Specifically, the one-way conducting devices D may be disposed inside the receiving module, at a junction between the transmitting module and the communication connection wire, or at a junction between the receiving module and the communication connection wire, or one or more thereof, for example, disposed at two positions shown in FIG. 3, so that a correct direction of signal transfer is ensured by using the one-way conducting feature of the device.

In some embodiments, a current limiting protector (such as a thermistor or a similar current limiting protection circuit) configured to limit the value of current, and an electrostatic discharge protector configured to prevent the circuit from being damaged by electrostatic discharge (such as a transient diode), may be further added in the transmitting module Tx and the receiving module Rx.

The current limiting protector and the electrostatic discharge protector may be deployed at one or more positions that form connection ports, for example, at the second control terminal, the signal receiving port, the enable-signal receiving port, and/or the fourth control terminal, so as to cut off or guide the excessive current or voltage to a ground terminal in time in a case of overcurrent or high instantaneous voltage to ensure the universal reliability and electrostatic discharge protection capability of the connection port of the module.

The communication circuit according to this embodiment of this application can implement two-way communication between two subsystems by using just a single communication connection wire, achieving the technical effects such as reduction of required connection ports.

Moreover, the single communication connection wire L is a high-voltage connection wire connected to a common positive pole of the system and bearing a voltage greater than 10V or 5V, and is more reliable than the conventional communication circuit design. Even if the ground wire between the subsystems is disconnected or the common ground is absent, the communication connection wire can still ensure effective communication function.

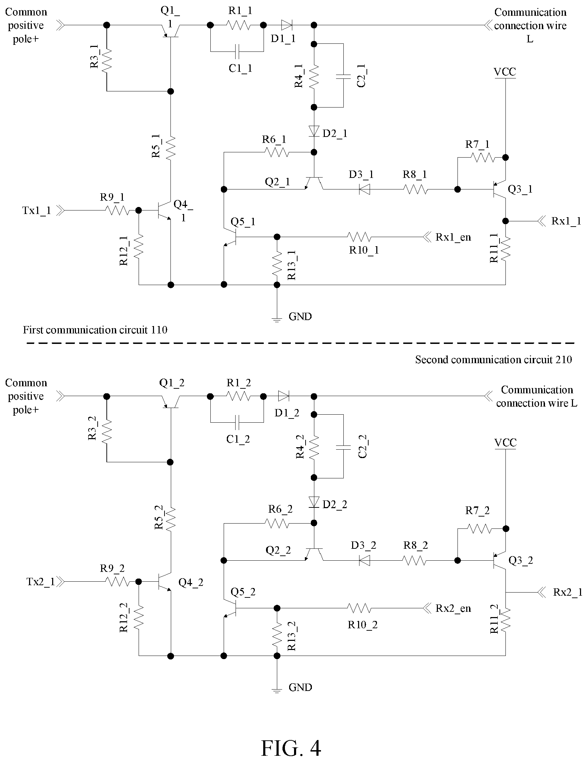

FIG. 4 is a schematic circuit diagram of a first communication circuit 110 and a second communication circuit 210 connected to a single communication connection wire L according to an embodiment of this application.

Signal transfer from the first communication circuit 110 to the second communication circuit 210 and signal transfer from the second communication circuit 210 to the first communication circuit 110 are two oppositely directed signal transfer processes. The first communication circuit 110 and the second communication circuit 210 can be implemented with the same circuit structure.

Therefore, in order to avoid repeated descriptions, the following describes in detail a signal transfer process and specific implementation of a communication circuit with reference to the schematic circuit diagram in FIG. 4, using an example in which the signal is transferred from the first communication circuit 110 (in the transmitting state) to the second communication circuit 210 (in the receiving state).

As shown in FIG. 4, the first transmitting module Tx1 of the first communication circuit 110 includes: a first transistor Q1_1, a fourth transistor Q4_1, a third resistor R3_1, a fifth resistor R5_1, a ninth resistor R9_1, and a twelfth resistor R12_1.

The first transistor Q1_1 and the third resistor R3_1 may form the first switch S11. A base of the first transistor Q1_1 is the first control terminal Ctrl1. The third resistor R3_1 is connected between the base and an emitter of the first transistor Q1_1 to serve as a bias resistor to achieve effects of blocking a leakage current and improving the reliability of the transistor in the cut-off state. The emitter and a collector of the first transistor Q1_1 are connected to the common positive pole+ and the communication connection wire L respectively.

The fourth transistor Q4_1, the twelfth resistor R12_1, and the ninth resistor R9_1 may form the second switch S12. A base of the fourth transistor Q4_1 is the second control terminal Ctrl2. The twelfth resistor R12_1 is connected between the base and an emitter of the fourth transistor Q4_1 to serve as a bias resistor to achieve effects of blocking the leakage current and improving the reliability of the transistor in the cut-off state. The ninth resistor R9_1 is connected between the base of the first transistor Q1_1 and a signal transmitting port Tx1_1 to serve as a current limiting resistor. A collector of the fourth transistor Q4_1 is connected to the base of the first transistor Q1_1 by the fifth resistor R5_1.

In some embodiments, the first transmitting module Tx1 of the first communication circuit 110 may further include: a first resistor R1_1, a first capacitor C1_1, and a first diode D1_1 to provide higher performance.

The first resistor R1_1 is a current limiting resistor connected between the collector of the first transistor Q1_1 and the communication connection wire L. The first capacitor C1_1 is connected across the first resistor R1_1 to help shape a voltage waveform. An anode of a one-way conducting first diode D1_1 is connected to the first resistor R1_1, and a cathode is connected to the communication connection wire L. A correct signal transfer direction of the transmitting module Tx1 is ensured by using the one-way conducting feature of the first diode.

Still referring to FIG. 4, the second receiving module Rx2 of the second communication circuit 210 connected to the first communication circuit 110 by the communication connection line L includes: a second transistor Q2 2, a third transistor Q3_2, a fifth transistor Q5 2, a sixth resistor R6 2, a seventh resistor R7_2, an eighth resistor R8_2, a tenth resistor R10_2, an eleventh resistor R11_2, and a thirteenth resistor R13_2.

The eleventh resistor R11_2 is a resistor R of the follower unit. The third transistor Q3_2 and the seventh resistor R7_2 may form a third switch S03 of the follower unit. Abase of the third transistor Q3_2 is the third control terminal Ctrl3. The seventh resistor R7_2 is connected between the base and an emitter of the third transistor Q3_2 to serve as a bias resistor. The emitter of the third transistor Q3_2 is connected to a constant voltage source VCC that provides a 3.3 V voltage. A collector of the third transistor Q3_2 is connected to one end of the eleventh resistor R11_2, and extends outward to form a signal receiving port Rx2_1. The other end of the eleventh resistor R11_2 is grounded.

The second transistor Q2_2 and the sixth resistor R6_2 form the fourth switch S21. Abase of the second transistor Q2_2 is the fourth control terminal Ctrl4. The sixth resistor R6_2 is connected between the base and an emitter of the second transistor Q2_2 to serve as a bias resistor to achieve effects of blocking the leakage current and improving the reliability of the transistor in the cut-off state.

The fifth transistor Q5 2, the tenth resistor R10_2, and the thirteenth resistor R13_2 form the fifth switch S22. Abase of the fifth transistor Q5_2 is the fifth control terminal Ctrl5. The thirteenth resistor R13_2 is connected between the base and an emitter of the fifth transistor Q5_2 to serve as a bias resistor to achieve effects of blocking the leakage current and improving the reliability of the transistor in the cut-off state. The tenth resistor R10_2 is connected between the base of the fifth transistor Q5_2 and an enable-signal receiving port Rx2_en to serve as a current limiting resistor.

In addition, the base of the third transistor Q3_2 is connected to the collector of the second transistor Q2_2 by the eighth resistor R8_2. The emitter of the second transistor Q2_2 is connected to the collector of the fifth transistor Q5 2, and the emitter of the fifth transistor Q5_2 is grounded.

In some embodiments, similar to the first transmitting module Tx1 of the first communication circuit 110, the second receiving module Rx2 of the second communication circuit 200 may further include: a fourth resistor R4_2, a second capacitor C2_2, a second diode D2_2, and a third diode D3_2 to provide higher performance.

The fourth resistor R4_2 is a current limiting resistor connected between the base of the second transistor Q2_2 and the communication connection wire L. The second capacitor C2_2 is connected across the fourth resistor R4_2 to help shape a voltage waveform.

An anode of the one-way conducting second diode D2_2 is connected to the fourth resistor R4_2, and a cathode thereof is connected to the base of the second transistor Q2_2. A correct signal transfer direction of the receiving module Rx2 is ensured by using the one-way conducting feature of the second diode. An anode of the third diode D3_2 is connected to one end of the eighth resistor R8_2, and a cathode thereof is connected to the collector of the second transistor Q2 2, serving a function of limiting the current transfer direction like the second diode.

In some embodiments, in determining and adjusting a specific resistance value of each resistor in the circuit structure shown in FIG. 4, optimization may be performed based on the voltage value of the common positive pole with a view to obtaining a relatively low circuit power consumption. Alternatively, based on the leakage current characteristics of the transistor, a bias resistor with a reasonable resistance value may be selected to prevent mistaken conduction of the transistor caused by excessive leakage current. In addition, an appropriate resistance value may be set based on different states of the transistor in different voltage ranges, so as to meet requirements on a communication waveform and a transfer delay of the level signal. Alternatively, a transistor and a diode that tolerate an appropriate voltage withstanding value may be selected and determined based on the voltage value of the common positive pole, so as to avoid a circuit failure caused by breakdown of a semiconductor device such as the transistor and the diode of the communication circuit in use.

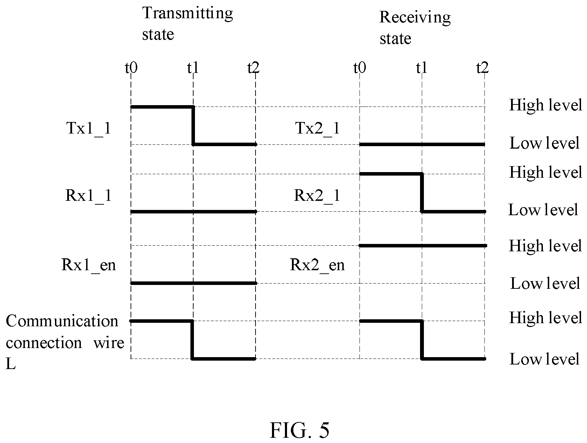

FIG. 5 is schematic diagram of a signal transfer process based on the schematic circuit diagram shown in FIG. 4, in which the signal is transferred from the first communication circuit 110 (in the transmitting state) to the second communication circuit 210 (in the receiving state).

As shown in FIG. 5, for the first communication circuit 110 in the transmitting state:

the first receiving module Rx1 is deactivated, the enable-signal receiving port Rx1_en receives a low-level enable signal delivered by a first processor, and the second transistor Q2_1, the third transistor Q3_1, and the fifth transistor Q5_1 of the first receiving module Tx1 are all in a cut-off state. The level of the signal receiving port Rx1_1 is pulled down to the level of the ground by the eleventh resistor R11_2 to form a low-level signal, and the low-level signal is delivered to the first processor.

The first transmitting module Tx1 implements the following signal transmitting process depending on different level signals received by the signal transmitting port Tx1_1:

The fourth transistor Q4_1 and the first transistor Q1_1 are turned on when the signal transmitting port Tx1_1 of the first transmitting module Tx1 receives a high-level signal delivered the first processor in a period from time t0 to time t1.

In this case, a pole voltage of the common positive pole+ can be delivered to a junction between the first transmitting module Tx1 and the communication connection wire L through the first transistor Q1_1, the first resistor R1_1, and the first diode D1_1, so as to form a high-level signal on the communication connection wire L. The high-level signal is transferred to the receiving module Rx2 of the second communication circuit.

The fourth transistor Q4_1 and the first transistor Q1_1 are cut off when the signal transmitting port Tx1_1 of the first transmitting module Tx1 receives a low-level signal in a period from time t1 to time t2. In this case, the pole voltage of the common positive pole+ is unable to pass through the first transistor Q1_1, so as to form a low-level signal on the communication connection wire L.

In this case, when the second receiving module Rx2 of the second communication circuit fails to receive the high-level signal from the communication connection wire L, the eleventh resistor R11_2 in the second receiving module pulls down the level of the signal receiving port Rx2_1 to a low level, and provides a low-level signal to the second processor.

Still referring to FIG. 5, for the second communication circuit 210 in the receiving state:

the second transmitting module Tx2 is deactivated, and the signal transmitting port Tx2_1 of the second transmitting module receives a continuous low-level signal delivered by the second processor, so that the fourth transistor Q4_2 and the first transistor Q1_2 of the second transmitting module Tx2 are kept in the cut-off state without transmitting a signal.

The enable-signal receiving port Rx2_en of the second receiving module Rx2 receives a high-level enable signal delivered by the second processor. The second receiving module is in the activated state, and implements the following signal receiving process depending on the change in the level signal of the communication connection wire L:

The communication connection wire L delivers the pole voltage of the common positive pole to the signal receiving port Rx2_1 of the second receiving module Rx2 in a period from time t0 to time t1, so that the second transistor Q2_2 is turned on. When the second transistor Q2_2 is turned on, the fifth transistor Q5_2 is also in the on-state accordingly.

When both the second transistor Q2_2 and the fifth transistor Q5_2 are turned on, the third transistor Q3_2 is also caused to be turned on. In this way, the level of the signal receiving port Rx2_1 is pulled up to 3.3 V, and the second processor can receive a high-level signal.

In a period from time t1 to time t2, the communication connection wire L is disconnected from the common positive pole, and fails to deliver the pole voltage to the signal receiving port Rx2_1 of the second receiving module Rx2, so that the second transistor Q2_2 is cut off. When the second transistor Q2_2 is cut off, the fifth transistor Q5_2 is also in the cut-off state accordingly.

When both the second transistor Q2_2 and the fifth transistor Q5_2 are in the cut-off state, the third transistor Q3_2 is also caused to be in the cut-off state. In this case, the level of the signal receiving port is pulled down to the level of the ground by the eleventh resistor R11_2, and the second processor can receive a low-level signal.

Based on the signal transfer process shown in FIG. 5, when a first subsystem 100 needs to transmit a signal to a second subsystem 200, a low-level enable signal may be delivered to the communication circuit by the first processor to deactivate the first receiving module Rx1, and a to-be-transmitted target signal is delivered to the communication circuit. The first transmitting module Tx1 of the communication circuit forms a level signal on the communication connection wire L, where the level signal is identical to the to-be-transmitted target signal.

In this case, the second subsystem 200 is in the receiving state, and the second transmitting module Tx2 is deactivated upon receiving a continuous low-level signal delivered by the second processor. The second receiving module Rx2 is activated upon receiving a high-level enable signal from the second processor, and can form a level signal on the signal receiving port Rx2_1, where the level signal is consistent with the level signal of the communication connection wire L. The second processor is connected to the signal receiving port Rx2_1 to acquire a target signal transmitted by the first processor.

In a preferred embodiment, when at least one of the first subsystem 100 or the second subsystem 200 supports a low-power-consumption mode, the low-power-consumption mode can be woken up based on a level signal transfer function available from the schematic circuit diagram shown in FIG. 4.

In an example in which the first subsystem 100 is in the low-power-consumption mode, upon entering the low-power-consumption mode, the first processor U1 of the first subsystem 100 can deliver a continuous low-level signal to the communication circuit to deactivate the first transmitting module Tx1, so that the communication circuit is in the receiving state. To activate and wake up the first processor U1, the second processor U2 of the second subsystem 200 may transmit a trigger signal to the first subsystem 100 through the second communication circuit 210 to wake up the first processor from the low-power-consumption mode.

Specifically, the first processor U1 that enters the low-power-consumption mode may use or configure any trigger mode as appropriate, such as an interruption trigger mode. Correspondingly, in an appropriate form of signal (for example, by transition from a high level to a low level), the trigger signal wakes up the first processor U1 from the low-power-consumption mode or triggers the first processor to exit from the low-power-consumption mode.

An embodiment of this application further provides a battery pack. The battery pack includes N cell modules and a battery management system configured to manage the N cell modules. The communication circuit described in one or more of the foregoing embodiments is included between different subsystems such as a current sampling system, a temperature detection system, and a central processing unit in the battery management system, so as to implement communication connection between any two subsystems.

In some embodiments, the communication circuit is further applicable to a charger paired with the battery pack, and is configured to implement communication connection between the charger and the battery pack or communication connection between one or more subsystems of the charger.

Based on the battery pack provided in the foregoing embodiment, an embodiment of this application further provides an electrical device. The electrical device includes the battery pack provided in one or more of the foregoing embodiments and a load, and uses the battery pack as a power source to supply power to the load.

The electrical device may be any type of device or system that uses electricity as an energy source, including but not limited to, an energy storage device such as an emergency power supply, a single-wheel, double-wheel, three-wheel, four-wheel, or multi-wheel electric vehicle, an electric tool such as an electric impact drill and an electric seeder, and an electrically driven unmanned aerial vehicle such as a fixed-wing aircraft, a rotor aircraft, a helicopter, or a quadrotor aircraft.

Finally, it needs to be noted that the foregoing embodiments are merely intended to describe the technical solutions of this application, but not to limit this application. Based on the concept of this application, the foregoing embodiments may be combined and the technical features in different embodiments may be combined, the steps may be implemented in any order, and many other variations may be made to different aspects of this application described above. For brevity, the variations are not provided herein in detail. Although this application is described in detail with reference to the foregoing embodiments, a person of ordinary skill in the art understands that modifications may still be made to the technical solutions described in the foregoing embodiments, or equivalent substitutions may still be made to some technical features in the technical solutions, without making the essence of the corresponding technical solutions depart from the scope of the technical solutions of the embodiments of this application.

## Claims

1. A communication circuit, **characterized in that**, the communication circuit comprises:
a transmitting module configured to transmit a signal through a communication connection wire when the communication circuit is in a transmitting state; and
a receiving module configured to receive the signal through the communication connection wire when the communication circuit is in a receiving state, wherein
when the communication circuit is in the transmitting state, the transmitting module is activated and the receiving module is deactivated; and, when the communication circuit is in the receiving state, the transmitting module is deactivated and the receiving module is activated;
wherein the communication circuit is configured to be connected to another communication circuit by the communication connection wire so the communication circuit and the another communication circuit connected by the communication connection wire share a common positive pole, and the communication connection wire is connected to the common positive pole.

2. The communication circuit according to claim 1, **characterized in that** the transmitting module comprises: a first controllable switch unit disposed between the communication connection wire and the common positive pole; and
the first controllable switch unit is configured to cut off or establish a connection between the communication connection wire and the common positive pole, so as to form different level signals on the communications connection wire.

3. The communication circuit according to claim 2, **characterized in that** when the communication circuit is in the receiving state, the first controllable switch unit keeps cutting off the connection between the communication connection wire and the common positive pole, so as to deactivate the transmitting module; and
when the communication circuit is in the transmitting state, the first controllable switch unit is configured to cut off or establish the connection between the communication connection wire and the common positive pole based on the transmitted signal, so as to form a level signal on the communications connection wire, wherein the level signal is consistent with the transmitted signal.

4. The communication circuit according to claim 2, **characterized in that** the first controllable switch unit comprises: a first switch with a first control terminal and a second switch with a second control terminal;
two ends of the first switch are connected to the common positive pole and the communication connection wire respectively; when the first switch is turned on, the connection between the common positive pole and the communication connection wire is established; and, when the first switch is cut off, the connection between the common positive pole and the communication connection wire is cut off;
the first control terminal is connected to the second switch, and is configured to control the first switch to turn on when the second switch is turned on, and control the first switch to cut off when the second switch is cut off; and
the second control terminal is configured to control the second switch to turn on or cut off based on the transmitted signal.

5. The communication circuit according to claim 4, **characterized in that** the first switch and the second switch each comprise several control elements, and the control elements comprise a transistor, a MOS transistor, and/or an optocoupler.

6. The communication circuit according to claim 1, **characterized in that** the receiving module comprises: a second controllable switch unit, a follower unit, and a signal receiving port;
the follower unit is connected to the signal receiving port; and
the second controllable switch unit is connected to the communication connection wire, and is configured to control the follower unit based on a level signal of the communication connection wire, and form a level signal at the signal receiving port, wherein the level signal is consistent with the level signal of the communication connection wire.

7. The communication circuit according to claim 6, **characterized in that** the follower unit comprises: a constant voltage source, a third switch with a third control terminal, and an eleventh resistor;
one end of the eleventh resistor is grounded, and the other end is connected to the signal receiving port;
the third switch is connected between the constant voltage source and the signal receiving port; and
the second controllable switch unit is connected to the third control terminal, and is configured to control the third switch to turn on or cut off, and form a high-level signal or a low-level signal at the signal receiving port.

8. The communication circuit according to claim 7, **characterized in that**
when the communication circuit is in the transmitting state, the second controllable switch unit controls the third switch to keep cutting off, so as to deactivate the receiving module;
when the communication circuit is in the receiving state, the second controllable switch unit is configured to control the third switch to cut off or turn on based on the level signal of the communication connection wire, and form a level signal at the signal receiving port, wherein the level signal is consistent with the level signal of the communication connection wire.

9. The communication circuit according to claim 7, **characterized in that** the second controllable switch unit comprises: an enable-signal receiving port configured to receive an enable signal, wherein the enable signal comprises a first enable signal used for activating the receiving module and a second enable signal used for deactivating the receiving module;
the second controllable switch unit is connected between the third control terminal and a ground, and is configured to cut off or establish a connection between the third control terminal and the ground, so as to turn on or cut off the third switch;
when the second enable signal is received, the second controllable switch unit keeps cutting off the connection between the third control terminal and the ground, so as to keep cutting off the third switch; and
when the first enable signal is received, the second controllable switch unit cuts off or establishes the connection between the third control terminal and the ground based on the level signal of the communication connection wire, so as to cut off or turn on the third switch.

10. The communication circuit according to claim 9, **characterized in that** the second controllable switch unit comprises: a fourth switch with a fourth control terminal and a fifth switch with a fifth control terminal, and the fifth switch is connected to the fourth switch in series;
the fourth control terminal is connected to the communication connection wire, and is configured to receive the level signal of the communication connection wire, and the fifth control terminal is connected to the enable-signal receiving port;
wherein, when the first enable signal is received, the fourth control terminal is configured to control the fourth switch and the fifth switch to turn on or cut off based on the level signal of the communication connection wire; and
when the second enable signal is received, the fifth control terminal is configured to control the fourth switch and the fifth switch to keep cutting off.

11. The communication circuit according to claim 10, **characterized in that** the third switch, the fourth switch, and the fifth switch each comprise several control elements, and the control elements comprise a transistor, a MOS transistor, and/or an optocoupler.

12. An electronic system, **characterized in that**, the electronic system comprises two subsystems, each subsystem includes processor and the communication circuit according to any one of claims 1 to 11;
the processor is connected to the communication circuit, and is configured to: control the communication circuit to switch between the receiving state and the transmitting state; and
one subsystem transmits, through the transmitting module when the communication circuit is in the transmitting state, a target signal to the other subsystem system connected to a communication connection wire; and, one subsystem receives, through the receiving module when the communication circuit is in the receiving state, the target signal transmitted by the other subsystem system.

13. The electronic system according to claim 12, **characterized in that** the processor works in at least one low-power-consumption mode, and the target signal comprises a wake-up signal used for causing the processor to exit the low-power-consumption mode;
when the processor enters the low-power-consumption mode, the processor controls the communication circuit to be in the receiving state; and
when the wake-up signal from the other subsystem system is received by the receiving module, the processor exits the low-power-consumption mode.

14. A battery pack, **characterized in that** the battery pack comprises the electronic system according to claim 13 or 14, and a cell module.

15. An electrical device, **characterized in that** the electrical device comprises: the battery pack according to claim 14, and a load powered by the battery pack.
